# EUROPÄISCHE PATENTSCHRIFT

(11) **EP 2 584 370 B1**
(45) Veröffentlichungstag und Bekanntmachung des Hinweises auf die Patenterteilung: **08.01.2020**
(21) Anmeldenummer: 12188810.1
(22) Anmeldetag: 17.10.2012
(51) Int. Cl.: G01R 33/563

(54) **NMR-Messung von Kontrastmittel-Konzentrationen**
NMR measurement of contrast agent concentrations
Mesure RMN de concentrations d'un agent de contraste

(30) Priorität: 20.10.2011 DE 102011084867
(43) Veröffentlichungstag der Anmeldung: 24.04.2013
(73) Patentinhaber: Universitätsklinikum Freiburg, 79106 Freiburg (DE)
(72) Erfinder: Kellner, Elias, 74193 Schwaigern (DE); Kiselev, Valerij, 79102 Freiburg (DE)
(74) Vertreter: Kohler Schmid Möbus Patentanwälte

(56) Entgegenhaltungen:
- US-A- 5 320 099
- US-A1- 2011 044 524
- US-B1- 6 389 304
- ELIAS KELLNER ET AL: "Arterial input function measurements for bolus tracking perfusion imaging in the brain", MAGNETIC RESONANCE IN MEDICINE, 1. Januar 2012 (2012-01-01), Seiten n/a-n/a, XP055050567, ISSN: 0740-3194, DOI: 10.1002/mrm.24319
- EUGENE G. KHOLMOVSKI ET AL: "Perfusion MRI with radial acquisition for arterial input function assessment", MAGNETIC RESONANCE IN MEDICINE, Bd. 57, Nr. 5, 1. Januar 2007 (2007-01-01) , Seiten 821-827, XP055050698, ISSN: 0740-3194, DOI: 10.1002/mrm.21210
- DOMINICK J O MCINTYRE ET AL: "A method for interleaved acquisition of a vascular input function for dynamic contrast-enhanced MRI in experimental rat tumours", NMR IN BIOMEDICINE, WILEY, LONDON, GB, Bd. 17, Nr. 3, 1. Mai 2004 (2004-05-01), Seiten 132-143, XP002647861, ISSN: 0952-3480, DOI: 10.1002/NBM.868 [gefunden am 2004-05-04]
- B F KJOLBY ET AL: "Realistic Model of Partial Volume Effect on the AIF in Dynamic Susceptibility Contrast Perfusion MRI", PROCEEDINGS OF THE INTERNATIONAL SOCIETY FOR MAGNETIC RESONANCE IN MEDICINE, JOINT ANNUAL MEETING ISMRM-ESMRMB, BERLIN, GERMANY, 19-25 MAY 2007, 5. Mai 2007 (2007-05-05), Seite 1442, XP055050902,
- P GALL ET AL: "Dynamic Perfusion Evaluation Based on a Tissue Model", PROCEEDINGS OF THE INTERNATIONAL SOCIETY FOR MAGNETIC RESONANCE IN MEDICINE, JOINT ANNUAL MEETING ISMRM-ESMRMB, BERLIN, GERMANY, 19-25 MAY 2007, 5. Mai 2007 (2007-05-05), Seite 1444, XP055050905,
- JOHANNES G. KORPORAAL ET AL: "Phase-based arterial input function measurements in the femoral arteries for quantification of dynamic contrast-enhanced (DCE) MRI and comparison with DCE-CT", MAGNETIC RESONANCE IN MEDICINE, Bd. 66, Nr. 5, 20. Mai 2011 (2011-05-20), Seiten 1267-1274, XP055050844, ISSN: 0740-3194, DOI: 10.1002/mrm.22905
- MATTHIAS J.P. VAN OSCH ET AL: "Measuring the arterial input function with gradient echo sequences", MAGNETIC RESONANCE IN MEDICINE, Bd. 49, Nr. 6, 16. Mai 2003 (2003-05-16), Seiten 1067-1076, XP055050845, ISSN: 0740-3194, DOI: 10.1002/mrm.10461

## Beschreibung

Die Erfindung betrifft ein Verfahren zur Messung der cerebralen Perfusion eines Lebewesens mittels Magnetresonanz (="MR") Bildgebung, wobei in einem Messvolumen im Gehirn des Lebewesens die Änderung des MR-Signals während der Passage eines Kontrastmittel-Bolus gemessen wird, wobei zusätzlich in einer Schicht, die von einer das Gehirn mit Blut versorgenden Arterie durchdrungen wird, weitere MR-Signale zur Ermittlung des zeitlichen Verlaufs der Konzentration des Kontrastmittels während der Bolus-Passage in der Arterie aufgenommen werden, und wobei während der Aufnahme der weiteren MR-Signale aus der Schicht (5) ein Magnetfeld-Gradient derart angelegt wird, dass pro Anregung jeweils ein 1-dimensionales Projektions-Bild der Schicht (5) entlang des Magnetfeld-Gradienten erzeugt wird.

Ein derartiges Verfahren ist aus Referenz [12] bekannt.

Ziel einer dynamischen Suszeptibilitäts gewichteten (=DSC) Messung ist es Perfusionsparameter wie cerebrales Blutvolumen (=CBV), cerebraler Blutfluss (=CBF) und mittlere Transitzeit (=MTT) lokal aufgelöst zu bestimmen. Injiziert man einen Kontrastmittelbolus in die Armvene so erzeugt die Passage dieses Bolus durch das Gehirn einen zeitlich veränderlichen Kontrast im MagnetResonanz-(=MR) Bild. Schnelle MR-Sequenzen (z.B. echo planar imaging (=EPI)) ermöglichen es die Passage dieses Kontrastmittelbolus zeitlich und örtlich aufgelöst zu messen. Aus so gemessenen Zeitreihen lässt sich die Änderung der Relaxationsrate für jedes Voxel bestimmen. Aus der Änderung der Relaxationsrate kann man die Kontrastmittelkonzentratiori näherungsweise bestimmen.

Die Bestimmung der oben genannten Parameter erfolgt durch Zuhilfenahme des tracer kinetic model [1, 2, 3]. Dieses Model stellt einen kausalen Zusammenhang zwischen dem Verlauf der Kontrastmittelkonzentration in der arteriellen Zufuhr (cᵢₙ (t)) und dem Verlauf der Kontrastmittelkonzentration im betrachteten Voxel (cₜ (t)) her. Aus dem Vergleich der beiden Verläufe können die oben genannten Parameter bestimmt werden.

Die durch das Kontrastmittel hervorgerufene Signaländerung ist im Gewebe und in den Arterien stark unterschiedlich. Der dynamische Bereich der Messung ist so beschränkt, dass sich Arterien und Gewebe nicht mit der selben Echozeit (=TE) optimal messen lassen. Bei kurzem TE ist es möglich die Änderung der Relaxationsrate in großen Gefäßen zu messen, wohingegen in Gewebe, wo CBV sehr klein ist, der Effekt des Kontrastmittels nicht mehr sichtbar ist. Bei langem TE ist der Effekt im Gewebe zwar gut sichtbar, die Magnetisierung in großen Gefäßen ist dann jedoch nahezu vollständig relaxiert und gibt dadurch kein Signal über dem Rauschniveau. Eine sehr kurze Echozeit würde zwar eine Messung des arteriellen Blutes ermöglichen, ist jedoch bildgebungstechnisch sehr aufwendig und wurde bisher nicht umgesetzt. In einem Standardprotokoll wird TE Gewebe optimiert gewählt. Es gibt Ansätze bei denen mehrere Echos von derselben Anregung aufgenommen werden [4,6], jedoch zeigt sich, dass die kürzeste Echozeit immer noch zu lang für die Messung des arteriellen Signals ist.

Die für die Perfusionsmessungen nötigen schnellen MR-Sequenzen wie z.B. EPI leiden unter einem Artefakt, bei dem die Inhomogenitäten des Hauptmagnetfeldes durch die damit verbundenen Änderungen der lokalen Larmorfrequenz zu einer Störung der Ortskodierung führen. Dies manifestiert sich in einer artifiziellen Verschiebung von Bildelementen [10]. Durch das Kontrastmittel entstehen solche Inhomogenitäten lokal in der Nähe von Blutgefässen. Dies äußert sich durch eine scheinbare Bewegung von Arterien durch das Bild während der Boluspassage.

Das Tracer kinetic Modell verlangt, dass cᵢₙ der direkte Input des betrachteten Voxels ist. Wie oben dargelegt, wird ersatzweise die arterielle Inputfunktion (=AIF) weiter entfernt im Gefäßbaum bestimmt. Auf diesem zusätzlichen Weg werden aufgrund der Blutflussverhältnisse die Form und die Ankunftszeit des Bolus verändert. Um diese Effekte zu minimieren wurde vorgeschlagen für ein gegebenes Gehimareal eine individuelle AIF zu bestimmen anstatt einer globalen AIF [5]. Damit einhergehend ist jedoch angesichts der verhältnismäßig niedrigen räumlichen Auflösung, dass solche lokale AIFs in Arterien die sehr klein im Vergleich zur Voxelgröße sind bestimmt werden. Dieser so genannte Partialvolumeneffekt führt zu einem gravierenden Verlust des arteriellen Beitrags im gemessenen Signal.

Um Partialvolumeneffekte zu minimieren haben van Osch et al. in [6] vorgeschlagen das komplexwertige Signal während der DSC Messung aufzuzeichnen. Wählt man ein Gefäß aus, das parallel zum Magnetfeld ist, so kann man den Beitrag des großen Gefäßes von dem des umgebenden Gewebes trennen. Ein solches Gefäß ist jedoch nur schwer auffindbar. Gerade Blutgefäße, die als lokale AIF benutzt werden können, liegen im Allgemeinen nicht parallel zum Magnetfeld und entziehen sich damit der Korrektur. Große Gefäße wie die Carotis Interna liegen zwar nahezu parallel zum Magnetfeld, die hohe Kontrastmittelkonzentration pro Voxel übersteigt jedoch den dynamischen Bereich einer typischen Messung.

Die momentan am häufigsten verwendete Methode der DSC-Auswertung beruht auf der Selektion einer globalen AIF. Die Selektion kann manuell erfolgen, indem der Benutzer ein Voxel auswählt, dessen Signal er für eine geeignete AIF hält.

Es hat sich gezeigt, dass die resultierenden Perfusionsparameter stark vom Benutzer abhängen. Um vergleichbarere und reproduzierbare Ergebnisse zu erhalten wurden deswegen Ansätze zur automatischen AIF-Selektion vorgeschlagen [7, 8, 9]. Ebenso wie bei die manuelle Selektion erhält man eine durch Partialvolumeneffekte und scheinbare Bewegung verzerrte AIF.

In dem Patent EP 0 958 503 B1 wird vorgeschlagen, die AIF im Hals des Patienten zu messen. Dabei wird ein ein-dimensionales Volumen, z.B. ein Zylinder, das die Carotiden enthält angeregt. Die dazu benötigten selektiven Anregungspulse sind sehr lang, weshalb die Messung des Blutsignals bei hohen Kontrastmittelkonzentrationen wegen zu langen TE zu ungenau wird. Eine denkbare Verkürzung der Pulslängen würde einhergehen mit einer Verschlechterung des Selektionsprofils, was zu Partialvolumenproblemen führen würde. Desweiteren lässt dieser Lösungsansatz offen, wie mit der durch das Kontrastmittel verursachten artifiziellen Verschiebung der Arterien umgegangen werden soll.

Van Osch et al. unternahmen einen weiteren Lösungsansatz und legten eine Anregungsschicht durch den Hals, die von den Arterien durchflossen wurde. Pro Schicht bei der Gehirnmessung versuchten van Osch et al. mit einer kurzen Echozeit die AIF zu bestimmen. Dabei wurde von der Halsschicht eine komplette 2-D Aufnahme erzeugt. Bei der Kontrastmittel-Boluspassage sank das Signal jedoch fast völlig unter das Rauschniveau. Zudem sind bei dieser Methode wegen der kurzen Echozeit mehrere Anregungen der Halsschicht pro Schicht im Gehirn nötig.

Die oben genannten Probleme des Standes der Technik lassen sich wie folgt zusammenfassen:
- Stark unterschiedliche Konzentrationen des Kontrastmittels in großen Gefäßen und Gewebe machen die genaue, gleichzeitige Messung von großen Gefäßen und Gewebe mit ein und denselben Sequenzparametern unmöglich.
- Für die Perfusionsmessung muss man die Sequenzparameter auf den Gewebekontrast optimieren. Das führt zu einem Abfall des arteriellen Signals unterhalb des Rauschniveaus.
- Arterielle Inputfunktionen die mit Mitteln des Standes der Technik bestimmt werden können sind von Partialvolumeneffekten verzerrt.
- Die Änderung der Larmorfrequenz durch das Kontrastmittel führt zu einer Verschiebung der Position der Arterien im aufgenommenen Bild.
- Die zeitliche Auflösung der DSC Messung ist gerade für die AIF sehr niedrig.

### Aufgabe der Erfindung

Der vorliegenden Erfindung liegt demgegenüber die Aufgabe zugrunde, ein Verfahren bereitzustellen, das eine gleichzeitige Messung des Kontrastmitteldurchflusses in das Gehirn versorgenden Gefäßen und Gehirn-Gewebe innerhalb ein und derselben Sequenz bei angepasstem dynamischem Bereich ermöglicht.

### Kurze Beschreibung der Erfindung

Diese Aufgabe wird erfindungsgemäß auf ebenso überraschend einfache wie wirkungsvolle Weise dadurch gelöst, dass in den Zeitintervallen zwischen den Anregungen der weiteren MR-Signale jeweils mindestens ein Hochfrequenz (="HF")-Impuls eingestrahlt wird, der eine Sättigung der Kernspin-Magnetisierung in der Schicht bewirkt, und dass die aufgrund einer vom Kontrastmittel hervorgerufenen Änderung der Larmor-Frequenz der Protonen-Spins im Blut erzeugte artifizielle Ortsverschiebung der Arterien-Position in den Projektionsbildern der Schicht gegenüber der tatsächlichen Position der Arterie zu einer Bestimmung der Konzentration des Kontrastmittels während der Bolus-Passage in der Arterie verwendet wird.

Im Gegensatz zu dem in Referenz [14] beschriebenen Verfahren sollen auf diese Weise 1-dimensionale Projektionsbilder erstellt werden.

Für die AIF Bestimmung wird eine Schicht im Hals angeregt, durch welche die interessierenden Karotiden möglichst senkrecht verlaufen und eine eindimensionale Bildgebung derselben durchgeführt, das heißt, dass die ganze Schicht auf eine Linie, die die zwei Karotiden verbindet, projiziert wird. Diese Projektion erfolgt mit der Hilfe eines Lesegradienten. Das Signal des stationären Gewebes wird gesättigt, um das Blutsignal relativ zum Gewebesignal durch den Inflow-Effekt zu verstärken. Der Inflow-Effekt entsteht dadurch, dass das Gewebe gesättigt wird und kaum noch Signale erzeugt, die Blut führenden Gefäße aber durch den Einfluss von frischem, ungesättigtem Blut weiter Signale erzeugen. Diese Technik ist zwar bekannt aus anderen Anwendungsbereichen, wie zum Beispiel der Angiographie [11, 13], wurde aber bisher noch nicht zur AIF Bestimmung verwendet. Der Inflow-Effekt führt zu einer deutlichen Kontrastverbesserung der blutführenden Gefäße gegenüber dem umliegenden Gewebe.

Die Halsschicht wird zeitlich zwischen jeder Messung einer Schicht im Gehirn gemessen, was eine schnelle Repetitionszeit der Messung in der Halsschicht von bis zu 100 ms zur Folge hat. Mit Methoden gemäß dem Stand der Technik wird eine Halsschicht ein Mal pro Gehimvolumen gemessen (also ca. jede 1.2s bis 1.8s).

Das erfindungsgemäße Verfahren hat gegenüber dem Stand der Technik deutliche Vorteile, die in ihrem Zusammenspiel die quantitative Bestimmung der Kontrastmittelkonzentration in den Arterien erstmals ermöglichen:
- Durch diese technische Umsetzung kann die Messung in der Halsschicht mit für das Blutsignal angepasster kurzer Echozeit (bis zu 0.6 ms) erfolgen. Dadurch bleibt das Blutsignal für alle Kontrastmittelkonzentrationen deutlich über dem Rauschniveau.
- Durch die Kombination von Projektionsbildgebung und Sättigung wird ein räumlich hochaufgelöstes Bild (z.B. 0,8mm pro Bildpunkt) der Arterien erhalten. Der positive Effekt dieser Kombination wurde von Nishimura et al. [11] bereits beschrieben, aber im Rahmen des erfindungsgemäßen Verfahrens erstmalig für die Messung der AIF eingesetzt.
- Das erfindungsgemäße Verfahren macht eine genaue Bestimmung des vom Gewebe herrührenden Hintergrundsignals möglich, auch wenn es sich durch das Kontrastmittel ändert.
- Die Arterien werden durch das pulsatile Signal wegen des Herzschlages erkannt. Das ermöglicht eine automatische Datenverarbeitung in praktischen Anwendungen.
- Das erfindungsgemäße Verfahren ist direkt klinisch anwendbar.
- Das erfindungsgemäße Verfahren löst ein trotz umfangreicher Tätigkeiten in diesem Forschungsfeld seit 13 Jahren ungelöstes Problem bei der Messung der cerebralen Perfusion.
- Diese Methode der Bestimmung der Kontrastmittelkonzentration hat den Vorteil, dass dank des erfindungsgemäßen Vorgehens die Arterien gut aufgelöst dargestellt werden können und man so den linearen Zusammenhang zwischen der Verschiebung und der Kontrastmittelkonzentration für eine unkomplizierte und genaue Bestimmung der Kontrastmittelkonzentration ausnutzen kann. Dies setzt eine hohe Ortsauflösung der Arterien bei einem guten Kontrast-zu-Rausch-Verhältnis voraus, was durch das erfindungsgemäße Verfahren erreicht wird.

### Bevorzugte Ausführungsformen der Erfindung

Bevorzugt ist eine Variante des erfindungsgemäßen Verfahrens, bei der die aufgrund einer vom Kontrastmittel hervorgerufenen Änderung der Relaxationszeiten der Protonen-Spins im Blut erzeugte Änderung der Amplituden und/oder Phasen der weiteren MR-Signale zu einer quantitativen Bestimmung der Konzentration des Kontrastmittels während der Bolus-Passage in der Arterie verwendet wird. Bei einer nicht ganz ausreichenden Ortsauflösung der Arterien kann diese Variante ergänzend zur Bestimmung der Kontrastmittelkonzentration herangezogen werden.

Dabei ist es vorteilhaft, wenn die Sättigung der Kernspin-Magnetisierung in der Schicht bewirkt wird durch Einstrahlung eines Inversionspulses in der Weise, dass sich die Kernspin-Magnetisierung in der Schicht bei der nächsten folgenden Anregung von weiteren MR-Signalen im Null-Durchgang befindet.

Bevorzugt wird auch eine Variante des erfindungsgemäßen Verfahrens, bei welchem die Sättigung der Kernspin-Magnetisierung in der Schicht bewirkt wird durch Einstrahlung eines oder mehrerer HF-Pulse zeitlich kurz (z.B. 40 ms) vor der Anregung der weiteren MR-Signale, insbesondere mehrerer zeitlich kurz aufeinander folgender HF-Impulse, die jeweils die Kernspins um einen kleinen Flipwinkel drehen. Dies kann im Vergleich zu den bisherigen Verfahren zu schnelleren Repetitionszeiten führen.

Eine weitere Variante des erfindungsgemäßen Verfahrens ist dadurch gekennzeichnet, dass jeweils zeitlich nach der Anregung und vor der Aufnahme der weiteren MR-Signale ein Magnetfeld-Gradient angelegt wird, der die Kernspin-Magnetisierung in der Schicht dephasiert, wodurch das Signal des Hintergrundgewebes weiter unterdrückt werden kann.

Besonders bevorzugt ist eine Variante des erfindungsgemäßen Verfahrens, bei welcher die weiteren MR-Signale aus der Schicht mit einer Repetitionszeit TR < 200ms, vorzugsweise TR ≈ 100ms, aufgenommen werden. Dies ermöglicht es, den Herzzyklus zeitlich aufgelöst zu messen. Dadurch können mögliche Einflüsse der Pulsatilität des Blutflusses auf die weiteren MR-Signale berücksichtigt werden.

Ebenfalls vorteilhaft ist eine Variante des erfindungsgemäßen Verfahrens, welche dadurch gekennzeichnet ist, dass die weiteren MR-Signale aus der Schicht (5) mit einer Gradienten-Echo-Zeit TE < 4ms aufgenommen werden. Dadurch bleibt das Blutsignal für alle Kontrastmittelkonzentrationen deutlich über dem Rauschniveau.

Eine weitere Variante des erfindungsgemäßen Verfahrens ist dadurch gekennzeichnet, dass die Änderung des MR-Signals während der Passage des Kontrastmittel-Bolus im Gehirn sowohl mit einem Gradienten-Echo als auch mit einem Spin-Echo bestimmt wird, wobei das Spin-Echo durch Refokussierung der für die Erzeugung des Gradienten-Echos angeregten Kernspins hervorgerufen wird. Durch dieses Merkmal lässt sich die Genauigkeit der Perfusions-Quantifizierung gegenüber den bisherigen Verfahren verbessern.

Zur Durchführung des erfindungsgemäßen Verfahrens eignet sich eine Tomographieeinrichtung mit einem ersten MR-Spulensystem zur Aufnahme einer ortsaufgelösten zeitlichen Reihe von MR-Bildern in einem Messvolumen im Gehirn eines Lebewesens, wobei die Zeitreihe von MR-Bildern den Durchgang eines in die Blutbahn des Lebewesens injizierten Kontrastmittels durch das Gehirn darstellt, dadurch gekennzeichnet, dass mindestens ein weiteres MR-Spulensystem vorgesehen ist, das eine lokale Aufnahmespule umfasst, welche in einer Schicht, die von einer das Gehirn mit Blut versorgenden Arterie durchdrungen wird, weitere MR-Signale zur Ermittlung des zeitlichen Verlaufs der Konzentration des Kontrastmittels während der Bolus-Passage in der Arterie zeitaufgelöst und zeitgleich mit der Messung der durch das erste MR-Spulensystem bestimmten zeitlichen Reihe von MR-Bildern misst. Eine solche Vorrichtung ist aus Referenz [15] bekannt, allerdings nicht in Kombination mit dem erfindungsgemäßen Verfahren.

Eine Weiterbildung dieser Vorrichtung ist dadurch gekennzeichnet, dass das weitere MR-Spulensystem eine Oberflächenspule umfasst. Dadurch kann das Signal-zu-Rausch-Verhältnis weiter verbessert werden.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in den Zeichnungen dargestellt und wird anhand von Ausführungsbeispielen näher erläutert.

Es zeigen:
- Fig. 1: eine beispielhafte, schematische Darstellung eines Tomographen zur Durchführung des erfindungsgemäßen Verfahrens;
- Fig. 2: ein Sequenzdiagramm eines Beispiels für ein erfindungsgemäßes Verfahren.

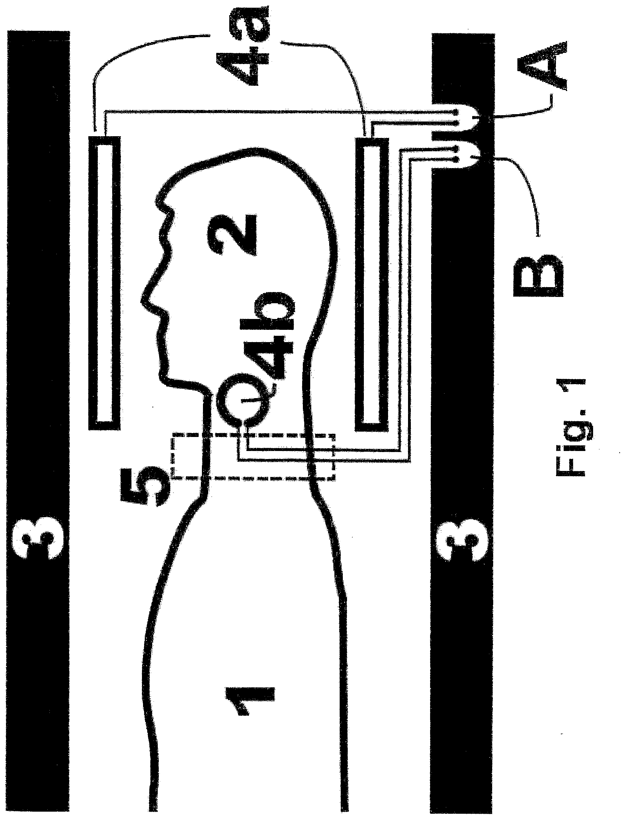

In der schematischen Darstellung **Fig. 1** ist ein **Gehirn 2** eines zu untersuchenden **Lebewesens 1** (in diesem Fall ein Mensch) in dem durch das **erste MR-Spulensystem 4a** definierten Messvolumen der **Tomographieeinrichtung 3** positioniert. Das zum Beispiel eine Oberflächenspule umfassende **weitere MR-Spulensystem 4b** wird am Hals des Patienten angebracht. Die Magnetisierung aus der **Anregungsschicht 5** dient als Signalquelle für das weitere MR-Spulensystem 4b.

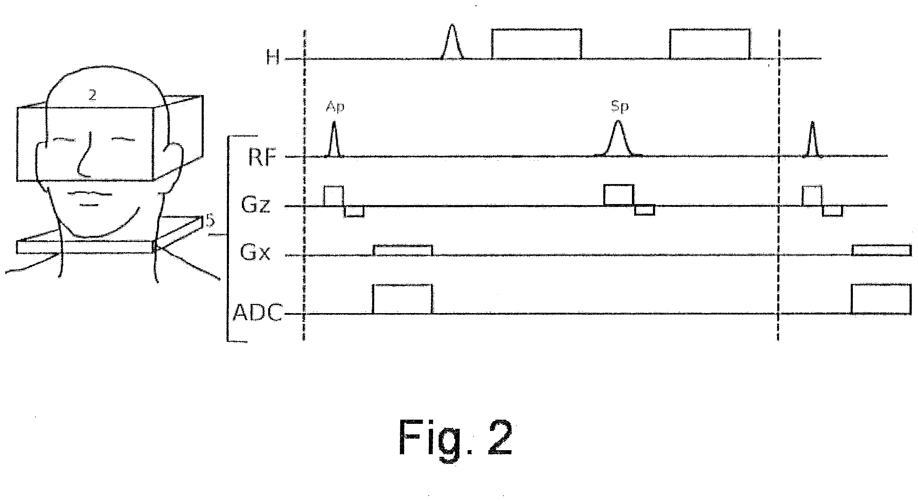

Das Sequenzdiagramm **Fig. 2** zeigt beispielhaft eine mögliche **Sequenzfolge G** bei der Messung im Gehirn 2. Gleichzeitig mit der Sequenzfolge G im Gehirn erfolgen in der Schicht 5, in der die Kontrastmittelkonzentration bestimmt werden soll, weitere Sequenzfolgen.

Die **Hochfrequenzsequenz RF** zeigt die Applikation eines **Anregungspulses Ap** und eines erfindungsgemäßen **Sättigungspulses Sp.**

Die **Schichtselektionssequenz Gz** stellt die Applikation eines Schichtselektionsgradienten dar, der die Erzeugung eines Projektionsbildes der Schicht ermöglicht.

Die **Lesesequenz Gx** zeigt die Applikation eines Lesegradienten.

Die **Auslesesequenz ADC** zeigt den zeitlichen Ablauf des Auslesens der Daten.

### Bezugszeichenliste

- 1: Zu untersuchendes Lebewesen
- 2: Gehirn
- 3: Tomographieeinrichtung
- 4a: Erstes MR-Spulensystem (Gewebe)
- 4b: Weiteres MR-Spulensystem (Kontrastmittel/Blut)
- 5: Angeregte Schicht
- A: Datenkanal erstes MR-Spulensystem
- B: Datenkanal weiteres MR-Spulensystem
- H: Gehirnsequenz
- RF: Hochfrequenzsequenz in der Schicht
- Gz: Schichtselektionsgradienten-Sequenz
- Gx: Lesegradienten-Sequenz
- ADC: Auslesesequenz
- Ap: Anregungspuls
- Sp: Sättigungspuls

### Literatur:

[1] L. Østergaard, R. Weisskoff, D. Chesler, C. Gyldensted, und B. Rosen: High resolution measurement of cerebral blood flow using intravascular tracer bolus passages. Part I: Mathematical approach and statistical analysis. Magn Reson Med, 36(5):715-25, 1996.
[2] L. Østergaard, A. Sørensen, K. Kwong, R. Weisskoff, C. Gyldensted, und B. Rosen: High resolution measurement of cerebral blood flow using intravascular tracer bolus passages. Part II: Experimental comparison and preliminary results. Magn Reson Med, 36(5):715-25, 1996.
[3] DE 60 024 073 T2
[4] R. Newbould, S. Skare, T. Jochimsen, M. Alley, M. Moseley, G. Albers, R. Bammer: Perfusion mapping with multiecho multishot parallel imaging EPI. Magn Reson Med, 58(1):70-81, 2007
[5] F. Calamante, M. Morup, L. Hansen: Defining a local arterial input function for perfusion MRI using independent component analysis. Magn Reson Med, 52(4):789-797, 2004
[6] M. van Osch, E. Vonken, M. Viergever, J. van der Grond, and C. Bakker: Measuring the arterial input function with gradient echo sequences. Magn Reson Med., 49:1067-76, 2003.
[7] T. J. Carroll, H. A. Rowley, and V. M. Haughton: Automatic calculation of the arterial input function for cerebral perfusion imaging with mr imaging. Radiology, 227(2):593-600, May 2003.
[8] US-A 6,546,275
[9] K. Mouridsen, S. Christensen, L. Gyldensted, and L. Ostergaard: Automatic selection of arterial input function using cluster analysis. Magn Reson Med, 55(3):524-531, Mar 2006.
[10] P Jezzard, and R.S. Balaban: Correction for geometric distortion in echo planar images from B0 field variations Magn Reson Med, 34(1) 65-73 Jul. 1995.
[11] Sanjay Mani, John Pauly, Steven Conolly, Craig Meyer, Dwight Nishimura: Background Suppression with Multiple Inversion Recovery Nulling: Applications to Projective Angiography, MRM 37:898-905, 1997
[12] US 6,389,304 B1
[13] US-A 5,320,099
[14] Eugene G. Kholmovski et al.: Perfusion MRI with radial acquisition for arterial input function assessment",Magn Reson Med, 57(5):821-827, Jan 2007.
[15] Dominik J O Mclntyre et al: "A method for interleaved acquisition of a vascular input function for dynamic contrast-enhanced MRI in experimental rat tumours", NMR in Biomedicine, Wiley, London, 17(3):132-143, May 2004

## Patentansprüche

1. Verfahren zur Messung der cerebralen Perfusion eines Lebewesens (1) mittels Magnetresonanz (="MR") Bildgebung, wobei in einem Messvolumen im Gehirn (2) des Lebewesens (1) die Änderung des MR-Signals während der Passage eines Kontrastmittel-Bolus gemessen wird, wobei zusätzlich in einer Schicht (5), die von einer das Gehirn (2) mit Blut versorgenden Arterie durchdrungen wird, weitere MR-Signale zur Ermittlung des zeitlichen Verlaufs der Konzentration des Kontrastmittels während der Bolus-Passage in der Arterie aufgenommen werden, und wobei während der Aufnahme der weiteren MR-Signale aus der Schicht (5) ein Magnetfeld-Gradient derart angelegt wird, dass pro Anregung jeweils ein 1-dimensionales Projektionsbild der Schicht (5) entlang des Magnetfeld-Gradienten erzeugt wird,
**dadurch gekennzeichnet,**
**dass** in den Zeitintervallen zwischen den Anregungen der weiteren MR-Signale jeweils mindestens ein Hochfrequenz (="HF")-Impuls eingestrahlt wird, der eine Sättigung der Kernspin-Magnetisierung in der Schicht (5) bewirkt,
und **dass** die aufgrund einer vom Kontrastmittel hervorgerufenen Änderung der Larmor-Frequenz der Protonen-Spins im Blut erzeugte artifizielle Ortsverschiebung der Arterien-Position in den Projektionsbildern der Schicht (5) gegenüber der tatsächlichen Position der Arterie zu einer Bestimmung der Konzentration des Kontrastmittels während der Bolus-Passage in der Arterie verwendet wird.

2. Verfahren nach Anspruch 1, **dadurch gekennzeichnet, dass** die aufgrund einer vom Kontrastmittel hervorgerufenen Änderung der Relaxationszeiten der Protonen-Spins im Blut erzeugte Änderung der Amplituden und/oder Phasen der weiteren MR-Signale zu einer quantitativen Bestimmung der Konzentration des Kontrastmittels während der Bolus-Passage in der Arterie verwendet wird.

3. Verfahren nach einem der vorhergehenden Ansprüche **dadurch gekennzeichnet, dass** die Sättigung der Kernspin-Magnetisierung in der Schicht (5) bewirkt wird durch Einstrahlung eines Inversionspulses in der Weise, dass sich die Kernspin-Magnetisierung in der Schicht (5) bei der nächsten folgenden Anregung von weiteren MR-Signalen im Null-Durchgang befindet.

4. Verfahren nach einem der vorhergehenden Ansprüche, **dadurch gekennzeichnet, dass** die Sättigung der Kernspin-Magnetisierung in der Schicht (5) bewirkt wird durch Einstrahlung eines oder mehrerer HF-Pulse zeitlich kurz vor der Anregung der weiteren MR-Signale.

5. Verfahren nach einem der vorhergehenden Ansprüche, **dadurch gekennzeichnet, dass** jeweils zeitlich nach der Anregung und vor der Aufnahme der weiteren MR-Signale ein Magnetfeld-Gradient angelegt wird, der die Kernspin-Magnetisierung in der Schicht (5) dephasiert.

6. Verfahren nach einem der vorhergehenden Ansprüche, **dadurch gekennzeichnet, dass** die weiteren MR-Signale aus der Schicht (5) mit einer Repetitionszeit TR < 200ms, vorzugsweise TR = 100ms, aufgenommen werden.

7. Verfahren nach einem der vorhergehenden Ansprüche, **dadurch gekennzeichnet, dass** die weiteren MR-Signale aus der Schicht (5) mit einer Gradienten-Echo-Zeit TE < 4ms aufgenommen werden.

8. Verfahren nach einem der vorhergehenden Ansprüche, **dadurch gekennzeichnet, dass** die Änderung des MR-Signals während der Passage des Kontrastmittel-Bolus im Gehirn (2) sowohl mit einem Gradienten-Echo als auch mit einem Spin-Echo bestimmt wird, wobei das Spin-Echo durch Refokussierung der für die Erzeugung des Gradienten-Echos angeregten Kernspins hervorgerufen wird.

## Claims

1. A method for measuring the cerebral perfusion of a living being (1) by means of magnetic resonance (="MR") imaging, wherein the change in the MR signal during passage of a contrast medium bolus in a measurement volume in the brain (2) of the living being (1) is measured,
wherein additionally in a slice (5) that is pervaded by an artery that supplies blood to the brain (2), further MR signals are recorded for determining the temporal progression of the concentration of the contrast medium during the bolus passage in the artery, and wherein during recording of the further MR signals from the slice (5), a magnetic field gradient is applied in such a manner that a one-dimensional projection image of the slice (5) along the magnetic field gradient is generated for each excitation,
**characterized in that**
in the time intervals between the excitations of the further MR signals at least one radio frequency (="RF") pulse is irradiated in each case, which causes saturation of the nuclear spin magnetization in the slice (5),
and that the artificial position shift of the artery position in the projection images of the slice (5) compared with the actual position of the artery, which is caused by a change in a Larmor frequency of proton spins in the blood due to the contrast medium, is used for determination of the concentration of the contrast medium during the bolus passage in the artery.

2. Method according to claim 1, **characterized in that** the change in amplitudes and/or phases of the further MR signals, which is caused by a change in relaxation times of proton spins in the blood due to the contrast medium, is used for a quantitative determination of the concentration of the contrast medium during the bolus passage in the artery.

3. The method according to any one of the preceding claims, **characterized in that** the saturation of the nuclear spin magnetization in the slice (5) is caused by irradiation of an inversion pulse in such a way that the nuclear spin magnetization in the slice (5) is located at a passage through zero on the next following excitation of further MR signals.

4. The method according to any one of the preceding claims, **characterized in that** the saturation of nuclear spin magnetization in the slice (5) is caused by irradiation of one or more RF pulses shortly before excitation of the further MR signals.

5. The method according to any one of the preceding claims, **characterized in that** a magnetic field gradient is applied after each excitation and before each recording of the further MR signals, which dephases the nuclear spin magnetization of the slice (5).

6. The method according to any one of the preceding claims, **characterized in that** the further MR signals from the slice (5) are recorded with a repetition time TR < 200 ms, preferably TR ≈ 100ms.

7. The method according to any one of the preceding claims, **characterized in that** the further MR signals from the slice (5) are recorded with a gradient echo time TE < 4ms.

8. The method according to any one of the preceding claims, **characterized in that** the change in the MR signal during passage of the contrast medium bolus is determined in the brain (2) both with a gradient echo and with a spin echo, wherein the spin echo is caused by refocusing the nuclear spins excited to generate the gradient echo.

## Revendications

1. Procédé de mesure de la perfusion cérébrale d'un être vivant (1) par imagerie par résonance magnétique (= « RM »), la variation du signal RM pendant le passage d'un bolus de produit de contraste étant mesurée dans un volume de mesure dans le cerveau (2) de l'être vivant (1), d'autres signaux RM étant en outre enregistrés dans une couche (5) qui est traversée par une artère alimentant le cerveau (2) en sang pour déterminer la variation temporelle de la concentration du produit de contraste pendant le passage du bolus dans l'artère, et un gradient de champ magnétique étant appliqué pendant l'enregistrement des autres signaux RM provenant de la couche (5), de telle sorte qu'une image de projection unidimensionnelle de la couche (5) le long du gradient de champ magnétique est produite à chaque excitation,
**caractérisé en ce**
**qu'**au moins une impulsion à haute fréquence (= « HF »), qui provoque une saturation de la magnétisation de spin nucléaire dans la couche (5), est émise dans chaque intervalle de temps entre les excitations des autres signaux RM,
et **que** le déplacement artificiel de la position de l'artère dans les images de projection de la couche (5) par rapport à la position réelle de l'artère en raison d'une modification de la fréquence de Larmor des spins de protons dans le sang provoquée par le produit de contraste est utilisé pour déterminer la concentration du produit de contraste pendant le passage du bolus dans l'artère.

2. Procédé selon la revendication 1, **caractérisé en ce que** la modification des amplitudes et/ou des phases des autres signaux RM produite en raison d'une modification des temps de relaxation des spins de protons dans le sang provoquée par le produit de contraste est utilisée pour une détermination quantitative de la concentration du produit de contraste pendant le passage du bolus dans l'artère.

3. Procédé selon l'une des revendications précédentes, **caractérisé en ce que** la saturation de la magnétisation de spin nucléaire dans la couche (5) est produite par émission d'une impulsion d'inversion de telle sorte que la magnétisation de spin nucléaire dans la couche (5) se trouve au passage par zéro lors de l'excitation suivante d'autres signaux RM.

4. Procédé selon l'une des revendications précédentes, **caractérisé en ce que** la saturation de la magnétisation de spin nucléaire dans la couche (5) est produite par émission d'une ou plusieurs impulsions HF peu de temps avant l'excitation des autres signaux RM.

5. Procédé selon l'une des revendications précédentes, **caractérisé en ce qu'**un gradient de champ magnétique, qui déphase la magnétisation de spin nucléaire dans la couche (5), est appliqué dans le temps chaque fois après l'excitation et avant l'enregistrement des autres signaux RM.

6. Procédé selon l'une des revendications précédentes, **caractérisé en ce que** les autres signaux RM provenant de la couche (5) sont enregistrés avec un temps de répétition TR < 200 ms, de préférence TR ≈ 100 ms.

7. Procédé selon l'une des revendications précédentes, **caractérisé en ce que** les autres signaux RM provenant de la couche (5) sont enregistrés avec un temps d'écho de gradient TE < 4 ms.

8. Procédé selon l'une des revendications précédentes, **caractérisé en ce que** la variation du signal RM pendant le passage du bolus de produit de contraste dans le cerveau (2) est déterminée aussi bien avec un écho de gradient qu'avec un écho de spin, l'écho de spin étant provoqué par refocalisation des spins nucléaires excités pour la production de l'écho de gradient.
